(19) Europäisches Patentamt

European Patent Office

Office européen des brevets

(11) **EP 0 881 777 B1**

(12) **EUROPÄISCHE PATENTSCHRIFT**

(45) Veröffentlichungstag und Bekanntmachung des Hinweises auf die Patenterteilung:
**16.01.2002 Patentblatt 2002/03**

(51) Int Cl.[7]: **H03M 3/02**

(21) Anmeldenummer: **98107367.9**

(22) Anmeldetag: **22.04.1998**

(54) **Vorrichtung zur Digital-Analog-Wandlung mit hoher Linearität**

High linearity digital to analog converter

Convertisseur numérique-analogique à haute linéarité

(84) Benannte Vertragsstaaten:
**DE FR GB IT**

(30) Priorität: **28.05.1997 DE 19722434**

(43) Veröffentlichungstag der Anmeldung:
**02.12.1998 Patentblatt 1998/49**

(73) Patentinhaber: **Infineon Technologies AG**
**81669 München (DE)**

(72) Erfinder:
• **Mauthe, Manfred**
**85655 Grosshelfendorf (DE)**
• **Sauerbrey, Jens**
**81549 München (DE)**

(74) Vertreter: **Reinhard - Skuhra - Weise & Partner**
**Postfach 44 01 51**
**80750 München (DE)**

(56) Entgegenhaltungen:
• **MATSUYA Y ET AL: "A 17-BIT OVERSAMPLING D-TO-A CONVERSION TECHNOLOGY USING MULTISTAGE NOISE SHAPING" IEEE JOURNAL OF SOLID-STATE CIRCUITS,US,IEEE INC. NEW YORK, Bd. 24, Nr. 4, 1. August 1989 (1989-08-01), Seiten 969-975, XP000066225 ISSN: 0018-9200**

**Beschreibung**

Bei konventionellen Wandlern mit Pipelining-Struktur oder mit sukzessiver Approximation aber auch bei sogenannten Delta-Sigma-Wandlern, deren Quantisierer eine große Anzahl von Quantisierungsstufen aufweist entstehen Linearitätsprobleme aufgrund von Bauteiletoleranzen in Widerstandsnetzwerken oder in entsprechenden Netzwerken mit geschalteten Kondensatoren. Durch Delta-Sigma-Wandler auf der Basis von sogenannten noise-shaping-Filtern kann, bei einer Ausgangswortbreite von 1 Bit, eine extreme Linearität erreicht werden und es sind keine besonderen Schritte für das Trimmen von Widerständen bzw. Kondensatoren erforderlich. Eine niedrige Ausgangsbitbreite des Quantisierers erfordert jedoch bei gleichem Durchsatz eine höhere Taktfrequenz, die jedoch aus technologischen Gründen nicht beliebig erhöht werden kann. Um bei einer bestimmten Taktfrequenz eine möglichst große Bandbreite zu erhalten benötigt man noise-shaping-Filter dritter oder höherer Ordnung, die jedoch, wie die Praxis gezeigt hat, sogar bei Ausgangswortbreiten von mehreren Bits zu Instabilitäten führten.

Aus dem Buch "Integrated Analog-To-Digital And Digital-To-Analog Converters" von Rudy Van De Plassche, Kluwer Academic Publishers, Boston/Dordrecht/London, Chapter 10, Seiten 367 bis 381, sind sogenannte noise-shaping-Filter erster, zweiter, dritter und höherer Ordnung bekannt. Weiterhin werden Seite 430 seg. MASH-Wandler beschrieben, die aus Kaskadierten Sigma-delta modulatoren bestehen. Weitere MASH-Wandler sind aus der Druckschrift "A 17-bit Oversampling D-to-A Conversion Technology Using Multistage Noise Shaping", M. tsuya et. al., IEEE Journal of Solid-State Circuits, 04 August 1989 bekannt.

Aus der US-Patentschrift 5,392,040 ist eine Bitkompressionsschaltung zur Verwendung in einem Delta-Sigma-D/A-Wandler bekannt, wobei Sampling-Daten in quantisierte Daten mit geringerer Wortbreite konvertiert werden und das Quantisierungsrauschen über ein noise-shaping-Filter rückgekoppelt wird.

Die der Erfindung zugrundeliegende Aufgabe besteht nun darin, eine Vorrichtung zur Digital-Analog-Wandlung anzugeben, die in ihrem Betriebsverhalten unbedingt stabil ist, die bei einer bestimmten Taktfrequenz eine möglichst große Bandbreite aufweist und die sich durch eine besonders hohe Linearität auszeichnet.

Diese Aufgabe wird erfindungsgemäß durch die im Patentanspruch 1 angegebenen Merkmale gelöst. Die Patentansprüche 2 bis 4 betreffen vorteilhafte Ausgestaltungen der Erfindung.

Die Erfindung wird nachfolgend anhand von bevorzugten Ausführungsbespielen näher erläutert. Dabei zeigt

Figur 1     ein Blockschaltbild eines bevorzugten Ausführungsbeispiels der Erfindung und

Figur 2     ein Detailschaltbild eines Teiles von Figur 1.

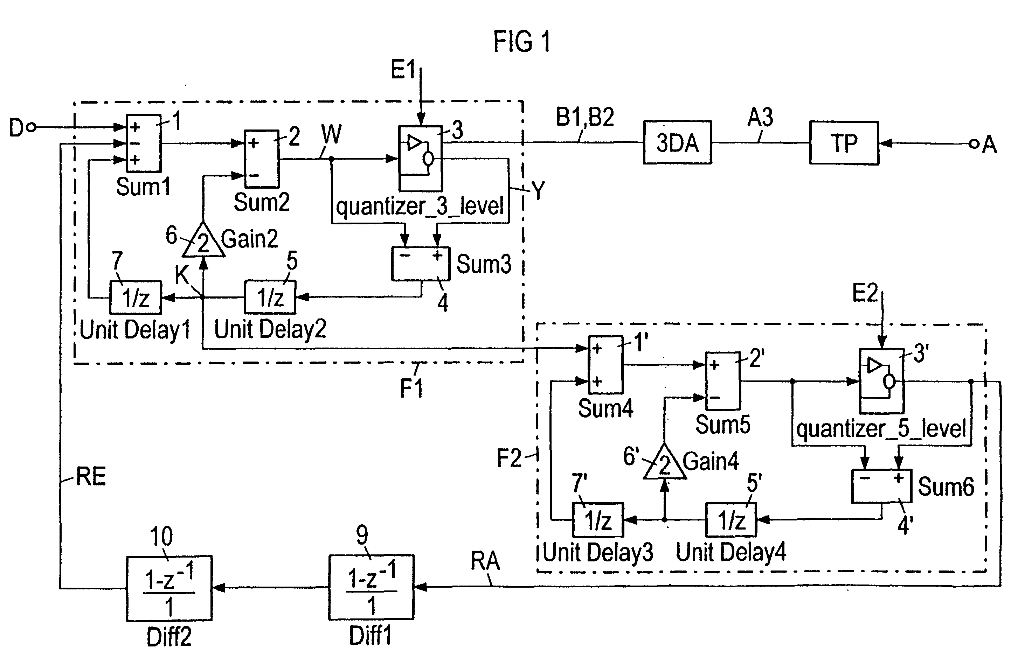

In Figur 1 ist ein bevorzugtes Ausführungsbeispiel einer erfindungsgemäßen Vorrichtung zur Digital-Analog-Wandlung mit zwei Delta-Sigma-Modulatoren (noise-shaping-Filter) F1 und F2 zweiter Ordnung dargestellt. Ein digitales Signal am Wandlereingang D, das beispielsweise 16 Bit umfaßt, wird hierbei dem ersten Modulator F1 zugeführt, der ein Modulatorausgangssignal Y und zwei Bereichsbits B1,B2 bildet, die mit Hilfe eines lediglich dreistufigen Digital-Analog-Wandlers 3DA und einem nachgeschaltetem Tiefpasses TP zu einem analogen Ausgangssignal A umwandelbar sind. Ferner wird aus dem Modulator F1 an einem Knoten K ein Signal ausgekoppelt, das als Eingangssignal für den zweiten Modulator F2 dient. Der Modulator F2 weist einen Rückkoppelausgang RA auf, der über zwei hintereinander geschaltete Differenzierer 9 und 10 mit einem Rückkoppeleingang RE des Modulators F1 verbunden ist.

Der Modulator F1 weist einen ersten Summierer 1 mit drei Eingängen auf, wobei ein positiver Eingang mit dem Wandlereingang D verbunden ist, wobei ein negativer Eingang mit dem Rückkoppeleingang RE und der Ausgang mit einem positiven Eingang eines zweiten Summierers 2 mit zwei Eingängen verbunden ist. Der Ausgang des Summierers 2 liefert ein Signal W und ist mit dem Eingang eines dreistufigen Quantisierers 3 verbunden, der das Ausgangssignal Y und die Bereichsbits B1 und B2 bildet, wobei die Bits B1 und B2 angeben, welche der drei Stufen am Quantisiererausgang vorliegt. Der Quantisierer 3 liefert beispielsweise an seinem Ausgang Y die Werte 1, 0 oder -1 als digitalen Wert. In einem dritten Summierer 4 wird das Eingangssignal W mit dem Ausgangssignal Y des Quantisierers 3 verglichen, wobei das Eingangssignal dem Summierer mit negativem Vorzeichen und das Ausgangssignal Y dem Summierer 4 mit positivem Vorzeichen zugeführt sind. Der Ausgang des Summierers 4 ist über eine Verzögerungseinheit 5 mit dem Knoten K verbunden, der seinerseits über einen Verstärker 6, der einen Verstärkungsfaktor 2 aufweist, mit einem negativen Eingang des Summierers 2 sowie über eine weitere Verzögerungseinheit 7 mit einem positiven Eingang des Summierers 1 verbunden ist. Bei einer Eingangswortbreite von X Bit muß der Modulator F1 mindestens mit X+3 Bit ausgelegt werden, damit kein Überlauf entsteht.

Der Modulator F2 ist im Grunde wie der Modulator F1 aufgebaut, wobei die entsprechenden Bestandteile anstelle von 1 ... 7 mit 1' ... 7' bezeichnet sind und wobei der Quantisierer 3' auch eine höhere Stufenzahl, beispielsweise 5 Stufen, aufweisen kann, da die Stufenzahl hierbei nicht in die Linearität des Wandlers eingeht jedoch mit zunehmender Stufenzahl die Stabilität verbessert wird. Bei fünf Stufen kann der Quantisierer beispielsweise an seinem Ausgang die Werte 1; 0,5; 0; -0,5 oder -1 als digitalen Wert liefern. Die beiden Modulatoren F1 und F2 sind als Kaskade geschaltet, das heißt der Knoten K ist mit einem positiven Eingang des Summierers 1' verbunden, der im Modulator F1 mit 1 bezeichnet ist und das digitale Eingangssignal D führt. Der Ausgang des Quantisierers 3' im Modulator F2 liefert das Rückkopplungsausgangssignal RA. Bei einer Eingangswortbreite von X Bit am Wandlereingang müßte der Modulator F2 bei voller Auflösung mindestens mit X+3+8 Bit ausgelegt werden, damit kein Überlauf entsteht. Es ist jedoch ausreichend nur die höchstwertigen X+3 Bits im Modulator F2 zu verarbeiten, da hierdurch das Signal/Rausch-Verhältnis nur unwesentlich verschlechtert wird.

Nimmt man an, daß der Quantisierer 3 ein Quantisierungsrauschen E1 und der Quantisierer 3' ein Quantisierungsrauschen E2 bewirkt, so kann die Übertragungsfunktion für die Zusammenschaltung der beiden Modulatoren F1 und F2 durch die Gleichung

$$Y(z)= D(z) + (1-z)^3*E1(z) + (1-z)^4*E2(z)$$

angegeben werden. Hieraus ergibt sich, daß das Quantisierungsrauschen des Quantisierers 3 mit der dritten Ordnung gedämpft und insgesamt somit ein Verhalten eines Modulators dritter Ordnung erzielt wird.

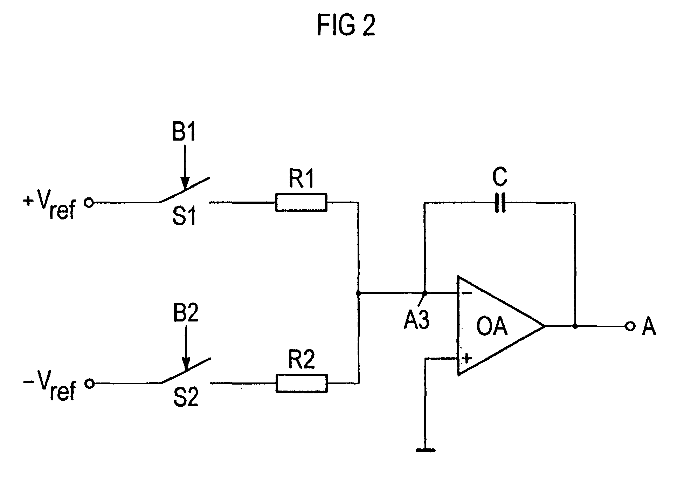

Figur 2 ist ein bevorzugtes Ausführungsbeispiel des dreistufigen Digital-Analog-Wandlers 3DA und des Tiefpasses TP dargestellt. Der dreistufige Digital-Analog-Wandlers 3DA besteht hierbei lediglich aus einem Schalter S1, der durch das Bit B1 angesteuert wird, einem Schalter S2, der durch das Bit B2 angesteuert wird, und zwei gleich großen Widerständen R1 und R2, wobei eine positive Referenzspannung $V_{ref}$ über den Schalter S1 und den Widerstand R1 sowie eine negative Referenzspannung $V_{ref}$ über den Schalter S2 und den Widerstand R2 jeweils auf den Ausgang A3 schaltbar ist, der seinerseits mit einem Tiefpaß in Form eines Integrators verbunden ist. Der Integrator weist beispielsweise einen Operationsverstärker OA auf und liefert an seinem Ausgang ein Analogsignal A, das über einen Kondensator C auf den Eingang A3 rückgekoppelt ist. Sind die beiden Bits B1 und B2 beide gleich 0 oder 1, so liegt am Eingang A3 die Spannung 0 Volt an, ist das Bit B1=1 und das Bit B2=0, so liegt $+V_{ref}$ am Eingang A3, und ist das Bit B2=1 und das Bit B1=0, so liegt $-V_{ref}$ am Eingang A3.

Wird die Schaltung von Figur 2 nicht mit Widerständen, sondern mit geschalteten Kapazitäten (SC-Technik) realisiert, so ist es möglich eine derartige Schaltung mit nur einer einzigen Schaltkapazität anstelle der doch mit Toleranzen behafteten beiden Widerstände R1 und R2 anzugeben und dadurch das höchste Maß an Linearität zu erreichen.

**Patentansprüche**

**1.** Vorrichtung zur Digital-Analog-Wandlung,

- bei der ein erster und zweiter Delta-Sigma-Modulator (F1, F2) zweiter Ordnung, ein erster und zweiter Differenzierer (9,10), ein dreistufiger Digital-Analog-Wandler (3DA) und ein Tiefpaß (TP) vorgesehen sind, wobei das Ausgangssignal des Tiefpasses (TP) gleichzeitig das Ausgangssignal (A) der Vorrichtung darstellt und wobei ein digitales Eingangssignal (D) dem ersten Modulator (F1) zugeführt ist,

- bei der ein Signal (K) zwischen einer ersten und zweiten Verzögerungsstufe (5, 7) des ersten Modulators einem Eingang des zweiten Modulators (F2) zugeführt ist,

- bei der ein Ausgangssignal (RA) des zweiten Modulators über die beiden hintereinander geschalteten Differenzierer (9, 10) einem Rückkoppeleingang (RE) des ersten Modulators zugeführt ist und

- bei der im ersten Modulator ein dreistufiger Quantisierer (3) vorgesehen ist, der ein erstes und ein zweites Bereichsbit (B1, B2) liefert, die von dem dreistufigen Digital-Analog-Wandler zu einem Analogsignal (A3) gewandelt werden und dieses Analogsignal dem Tiefpaß (TP) zugeführt ist.

**2.** Vorrichtung nach Anspruch 1,
bei der sowohl der erste Modulator (F1) als auch der zweite Modulator (F2) einen der Reihe nach in Serie geschalteten jeweiligen ersten Summierer (1, 1'), einen jeweiligen zweiten Summierer (2, 2') und einen jeweiligen Quantisierer (3, 3') aufweisen, dessen Eingangs- und Ausgangssignal über einen dritten Summierer (4, 4') verglichen und das Vergleichssignal über die jeweilige erste Verzögerungsstufe (5, 5') und einen jeweiligen Verstärker (6, 6') dem jeweiligen zweiten Summierer (2) zugeführt ist sowie über die jeweilige erste Verzögerungsstufe und die jeweilige Verzögerungsstufe (7, 7') dem jeweiligen ersten zweite Summierer zugeführt ist.

**3.** Vorrichtung nach Anspruch 1 oder 2,

bei der der dreistufige Digital-Analog-Wandler (3DA) und der Tiefpaß (TP) dadurch gebildet sind,
daß ein Operationsverstärker (OA) vorgesehen ist, dessen Ausgang gleichzeitig den Ausgang (A) der Vorrichtung bildet und der über eine Kapazität C auf einen invertierenden Eingang (A3) des Operationsverstärkers rückgekoppelt ist, wobei dieser Eingang sowohl über einen ersten Schalter (S1), der durch das erste Bereichsbit (B1) ansteuerbar ist, und einen Widerstand (R1) mit einer positiven Referenzspannung ($V_{ref}$) als auch über einen zweiten Schalter (S2), der über das zweite Bereichsbit (B2) ansteuerbar ist, und einem zweiten Widerstand (R2) mit einer negativen Referenzspannung (-V_ref) verbindbär ist.

4. Vorrichtung nach Anspruch 1 oder 2,

bei der der dreistufige Digital-Analog-Wandler (3DA) mit geschalteten Kapazitäten gebildet ist, wobei Schalter durch die Bereichsbits (B1, B2) angesteuert sind,
und der Tiefpaß (TP) durch einen Operationsverstärker (OA), der über eine Kapazität (C) auf seinen invertierenden Eingang (A3) rückgekoppelt ist, gebildet ist.

## Claims

1. Digital-analog conversion device,

   - in which a first and second delta-sigma modulator (F1, F2) of the second order, a first and second differentiator (9, 10), a three-stage digital-analog converter (3DA) and a low-pass filter (TP) are provided, the output signal of the low-pass filter (TP) simultaneously constituting the output signal (A) of the device, and a digital input signal (D) being fed to the first modulator (F1),
   - in which a signal (K) between a first and second delay stage (5, 7) of the first modulator is fed to an input of the second modulator (F2),
   - in which an output signal (RA) of the second modulator is fed to a feedback input (RE) of the first modulator via the two differentiators (9, 10) which are connected in series, and
   - in which provided in the first modulator is a three-stage quantizer (3) which supplies a first and a second area bit (B1, B2) which are converted by the three-stage digital-analog converter into an analog signal (A3) and this analog signal is fed to the low-pass filter (TP).

2. Device according to Claim 1, in which both the first modulator (F1) and the second modulator (F2) have a respective first summing element (1, 1'), a respective second summing element (2, 2') and a respective quantizer (3, 3') which are successively connected in series, the input and output signal of said quantizer (3, 3') being compared by means of a third summing element (4, 4'), and the comparison signal being fed to the respective second summing element (2) via the respective first delay stage (5, 5') and a respective amplifier (6, 6'), and being fed to the respective first second summing element via the respective first delay stage and the respective delay stage (7, 7').

3. Device according to Claim 1 or 2, in which the three-stage digital-analog converter (3DA) and the low-pass filter (TP) are formed by virtue of the fact that an operational amplifier (OA) is provided whose output simultaneously forms the output (A) of the device and which is fed back to an inverting input (A3) of the operational amplifier via a capacitor C, this input being capable of being connected both to a positive reference voltage (V_ref) via a first switch (S1), which can be driven by the first area bit (B1), and a resistor (R1), and to a negative reference voltage (- V_ref) via a second switch (S2) which can be driven via the second area bit (B2), and a second resistor (R2).

4. Device according to Claim 1 or 2, in which the three-stage digital-analog converter (3DA) is formed with switched capacitors, switches being driven by the area bits (B1, B2), and the low-pass filter (TP) being formed by an operational amplifier (OA) which is fed back to its inverting input (A3) via a capacitor (C).

## Revendications

1. Dispositif de conversion numérique/analogique,

   - dans lequel des premier et second modulateurs delta-sigma (F1, F2) du second ordre, des premier et second différentiateurs (9, 10), un convertisseur numérique/analogique à trois étages (3DA), un filtre passe-bas (TP) sont prévus, le signal de sortie du filtre passe-bas (TP) représentant simultanément le signal de sortie (A) du dispositif, et un signal d'entrée numérique (D) étant envoyé au premier modulateur (F1),
   - dans lequel un signal (K) est envoyé entre des premiers et seconds étages de retardement (5, 7) du premier modulateur, à une entrée du second modulateur (F2),
   - dans lequel un signal de sortie (RA) du second modulateur est envoyé par l'intermédiaire des deux différentiateurs (9, 10) branchés en série, à une ligne de réaction (RE) du premier modulateur, et
   - dans lequel dans le premier modulateur, il est prévu un quantificateur à trois étages (3), qui délivre des premier et second bits de zone (B1, B2), qui sont convertis par le convertisseur numérique/analogique à trois étages en un signal analogique (A3), et ce signal analogique est envoyé au filtre passe-bas (TP).

2. Dispositif selon la revendication 1,
   dans lequel aussi bien le premier modulateur (F1) que le second modulateur (F2) comportent), branchés en série selon l'ordre suivant un premier sommateur respectif (1, 1' un second sommateur respectif (2, 2') et un quantificateur respectif (3, 3'), dont le signal d'entrée et le signal de sortie sont comparés par l'intermédiaire d'un troisième sommateur (4, 4'), et le signal de comparaison est envoyé par l'intermédiaire du premier étage de retardement respectif (5, 5') et d'un amplificateur respectif (6, 6') au second sommateur respectif (2), et est envoyé, par l'intermédiaire du premier étage de retardement respectif et de l'étage de retardement respectif (7, 7'), au premier sommateur respectif.

3. Dispositif selon la revendication 1 ou 2, dans lequel le convertisseur numérique/analogique à trois étages (3DA) et le filtre passe-bas (TP) sont formés sans le fait qu'il est prévu un amplificateur opérationnel (OA), dont la sortie forme simultanément la sortie (A) du dispositif et qui est couplée par réaction, par l'intermédiaire d'une capacité C, à une entrée inverseuse (A3) de l'amplificateur opérationnel, cette entrée étant reliée aussi bien par l'intermédiaire d'un premier interrupteur (S1), qui peut être commandé par le premier bit de zone (B1), et d'une résistance (R1) ayant une tension de référence positive ($V_{ref}$), que par l'intermédiaire d'un second interrupteur (S2), qui peut être commandé par l'intermédiaire du second bit de zone (B2), et d'une seconde résistance (R2), à une tension de référence négative (-$V_{ref}$).

4. Dispositif selon la revendication 1 ou 2, dans lequel le convertisseur numérique/analogique à trois étages (3DA) est formé par des capacités commutées, des interrupteurs étant commandés par les bits de zone (B1, B2), le filtre passe-bas (TP) est formé par un amplificateur opérationnel (OA) qui est couplé par réaction par l'intermédiaire d'une capacité (C) à son entrée inverseuse (A3).

## FIG 1

EP 0 881 777 B1

# FIG 2

EP 0 881 777 B1